# EUROPEAN PATENT APPLICATION

(11) **EP 1 808 907 A1**
(43) Date of publication of application: **18.07.2007**
(21) Application number: 06250229.9
(22) Date of filing: 17.01.2006
(51) Int. Cl.: H01L 41/04

(54) **Piezoelectric actuator**

(71) Applicant: Delphi Technologies, Inc., Troy, MI 48007 (US)
(72) Inventor: Hargreaves, Andrew John, Boughton Under Blean ME13 9BH (GB)
(74) Representative: Hopley, Joanne Selina

(57) **Abstract**

A piezoelectric actuator arrangement for use in a fuel injector including a piezoelectric body (10) and a positive actuator terminal (22) and a negative actuator terminal (24) across which a voltage and/or charge is applied, in use, so as to actuate the piezoelectric body (10). An electrical connection means (30) electrically connects with the positive and negative actuator terminals (22, 24) so as to enable voltage and/or charge supply to the positive and negative actuator terminals (22, 24). A conductive element (42, 44), typically a leaf spring, is operable to connect with the positive and negative actuator terminals (22, 24) so as to allow charge to dissipate from the stack (10) when the electrical connection between the electrical connection means (30) and the positive and negative actuator terminals (22, 24) is broken and to disconnect from the positive and negative actuator terminals (22, 24) when the electrical connection means (30) and the positive and negative actuator terminals (22, 24) are electrically connected.

## Description

### Technical Field

The invention relates to a piezoelectric actuator. In particular, but not exclusively, the invention relates to a piezoelectric actuator for use in a fuel injector of a fuel injection system of an internal combustion engine.

### Background to the Invention

It is known to provide a fuel injector for an automotive engine with a piezoelectric actuator for controlling the injection of fuel into the engine. By way of example, our co-pending European patent application EP 1174615 describes a fuel injector in which a piezoelectric actuator is arranged to control movement of an injector valve needle towards and away from a valve seating, so as to control the injection of fuel. The actuator includes a stack of piezoelectric elements which is controlled by means of voltage and/or charge transfer across the piezoelectric stack. This has the effect of varying the length of the stack and, consequently, the position of the injector valve needle.

The actuator includes an electrical connector having positive and negative terminals which connect with a respective one of positive and negative stack electrodes. It is one problem with piezoelectric actuators of the aforementioned type that the stack behaves like an electrical capacitor and so can store electric charge. Large voltages are typically generated within the stack, due to changes in temperature, shock loads and forces that are applied to the stack or the injector, when in use. As a result of charge build up, if the positive and negative terminals of the electrical connector are shorted through inadvertent human contact, a large and potentially fatal electrical shock can occur.

It is known to provide the electrical connector with a "shunt" resistor, connected in parallel across the connector terminals, which provides a short circuit to drain the charge that accumulates within the stack over a relatively long period of time. In other known actuators a resistor is not provided in the electrical connector itself but is connected in parallel across the stack external electrodes, for example by welding or soldering, to provide the same charge drain function. However, the resistance of the shunt resistor has to be selected as a compromise between safety and efficiency/performance, as the presence of the resistor must not affect the relatively short duration current pulses of normal operation.

It is a further disadvantage of providing a shunt resistor across the stack that the ability to implement diagnostic monitoring of the injector is compromised as a result of the inevitable leakage current that flows through the shunt resistor. It is important to be able to detect a short circuit in the injector at all times so as to ensure that an appropriate injector control strategy can be implemented to accommodate the fault (for example, to prevent damage to other injectors of the system).

It is an object of the present invention to provide a piezoelectric actuator in which the aforementioned problems are alleviated or removed altogether.

### Summary of Invention

According to a first aspect of the invention, there is provided a piezoelectric actuator arrangement for use in a fuel injector, the piezoelectric actuator comprising a piezoelectric body, and a positive actuator terminal and a negative actuator terminal across which a voltage and/or charge is applied, in use, so as to actuate the piezoelectric body. An electrical connection means is provided to enable voltage and/or charge supply to the positive and negative actuator terminals. A conductive element is operable to connect with the positive and negative actuator terminals so as to allow charge to dissipate from the stack when the connection between the electrical connection means and the positive and negative actuator terminals is broken and to disconnect from the positive and negative actuator terminals when the electrical connection means and the positive and negative terminals are connected.

In one embodiment, the conduction means includes a movable conductive element which is urged by means of a biasing force into connection with the positive and negative actuator terminals when the electrical connection between the electrical connection means and the positive and negative actuator terminals is broken.

The invention provides the advantage that the conductive element is only connected with the positive and negative actuator terminals when the electrical connection means is removed from the stack. In other words, in normal use when the electrical connection means is connected with the positive and negative actuator terminals, the conductive element is disconnected and so has no detrimental effect on the charge within the stack. A further advantage of this is that the efficiency of the controller for the actuator is improved as there is no 'wasted' current flowing through the conductive element when the actuator is operational.

For example, the electrical connection means may include a connector body which urges the conductive element out of contact with the positive and negative actuator terminals, against the biasing force, when the electrical connection means is electrically connected with the positive and negative actuator terminals.

In one embodiment, the conductive element serves to connect the positive and negative actuator terminals to ground (i.e. both the positive and negative actuator terminals are grounded) when the electrical connection between the electrical connection means and the positive and negative actuator terminals is broken.

By way of example, the piezoelectric actuator includes a first conductive element which connects the positive actuator terminal to ground and a second conductive element which connects the negative actuator terminal to ground when the electrical connection between the electrical connection means and the positive and negative actuator terminals is broken.

Preferably, each of the first and second conductive elements includes a ground portion, preferably in permanent connection with ground potential, and a movable contact portion which is movable to connect with a respective one of the positive and negative actuator terminals.

The first and second conductive elements (or the single conductive element) may themselves be resilient elements. This conveniently provides the biasing function and the shorting function in a single element for each actuator terminal. Alternatively, each of the first and second conductive elements (or the single conductive element) is biased by means of a separate resilient element into connection with the respective one of the positive and negative actuator terminals. In any case, the resilient elements are conveniently leaf springs.

The electrical connection means preferably includes positive and negative connector terminals for electrical connection with respective ones of the positive and negative actuator terminals, wherein the connector body is a tubular connector body housing at least a part of the positive and negative connector terminals.

In another embodiment, the conduction means may include a movable conductive element which connects across the positive and negative terminals, rather than connecting the elements to ground directly.

In one example, the conductive element is in the form of a resilient element which is biased into a position in which it connects across the positive and negative actuator terminals when the electrical connection between the electrical connection means and the positive and negative actuator terminals is broken.

In another embodiment where the actuator terminals are shorted together, the conductive element may be biased by means of a separate resilient element, such as a leaf spring, into a position in which it connects across the positive and negative actuator terminals when the electrical connection between the electrical connection means and the positive and negative actuator terminals is broken.

The piezoelectric body preferably includes a stack of piezoelectric elements formed from a piezoelectric material.

According to a second aspect of the invention, there is provided a fuel injector for use in an internal combustion engine, the fuel injector including an actuator in accordance with the first aspect of the invention for controlling operation of a fuel injector valve needle.

It will be appreciated that preferred and/or optional features of the actuator of the first aspect of the invention may be incorporated within the injector of the second aspect of the invention, alone or in appropriate combination.

### Brief Description of Drawings

The invention will now be described, by way of example only, with reference to the accompanying drawings in which;
Figure 1 is a schematic diagram of a piezoelectric actuator of the type used in the present invention,
Figure 2 is a schematic diagram of an upper end of the piezoelectric actuator in Figure 1 illustrating positive and negative terminals of the actuator;
Figure 3 is a schematic diagram of a piezoelectric actuator of Figures 1 and 2, when fitted with an electrical connector for enabling voltage supply to the actuator, in use;
Figure 4 is a section top view of the piezoelectric actuator in Figure 3; and
Figure 5 is a side view of the piezoelectric actuator and the electrical connector in Figures 3 and 4 during an assembly stage.

### Detailed Description of Preferred Embodiments

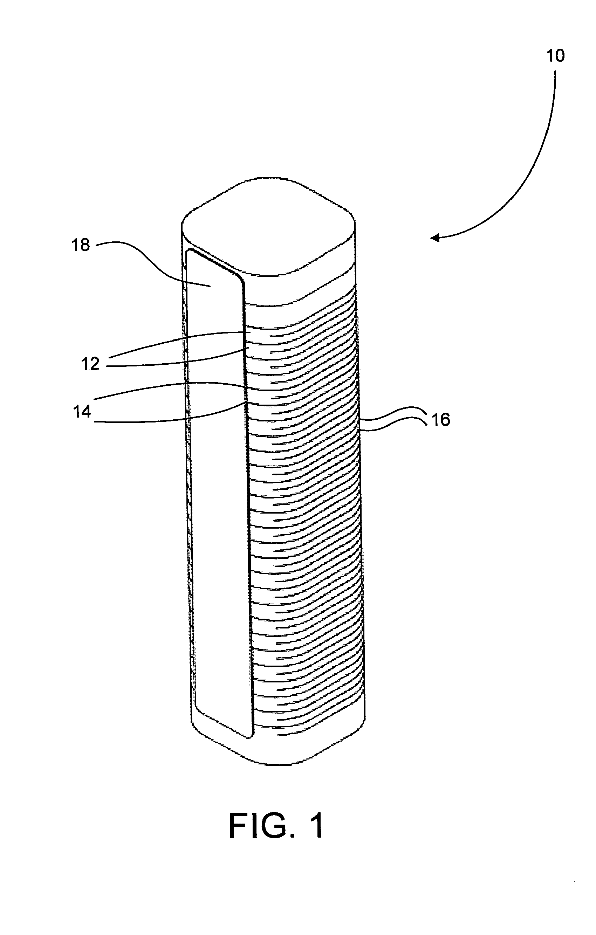

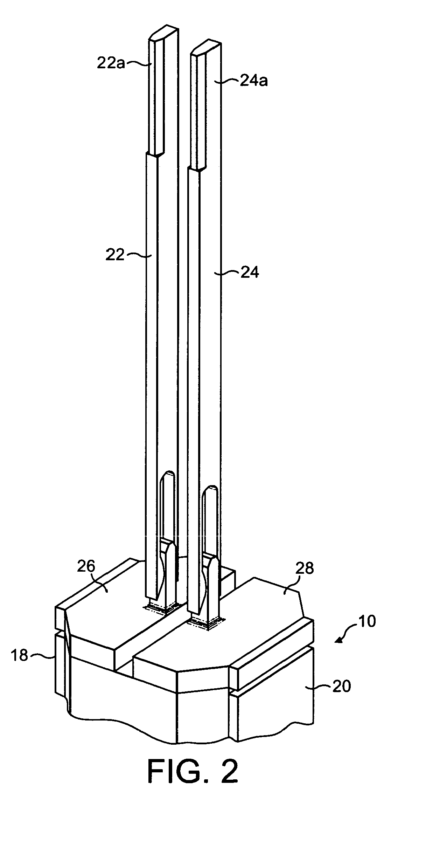

The piezoelectric actuator of the invention is suitable for use in a fuel injector for a compression ignition internal combustion engine. By way of example, our co-pending European patent application EP 1174615 describes a fuel injector in which a piezoelectric actuator controls movement of an injector valve needle to control the injection of fuel into the engine. Movement of the valve needle is controlled by means of voltage and/or charge transfer across a piezoelectric actuator, such as that shown in Figures 1 and 2.

The piezoelectric actuator has a piezoelectric stack structure 10 formed from a plurality of piezoelectric layers or elements 12 (only two of which are identified) separated by a plurality of internal electrodes 14, 16. Figure 1 is illustrative only and in practice the stack structure 10 would include a greater number of layers and electrodes than those shown and with a much smaller spacing. The internal electrodes 14, 16 are divided into two groups: a positive group of electrodes (only two of which are identified at 14) and a negative group of electrodes (only two of which are identified at 16). The positive group of electrodes 14 are interdigitated with the negative group of electrodes 16, with the electrodes of the positive group connecting with a positive external electrode 18 of the actuator and the negative group of electrodes connecting with a negative external electrode 20 (visible only in Figure 1) on the opposite side of the stack 10 to the positive external electrode 18.

Typically, the piezoelectric material from which the elements 12 are formed is a ferroelectric material such as lead zirconate titanate, also known by those skilled in the art as PZT. The actuator construction results in the presence of active regions between internal electrodes of opposite polarity. In use, when a voltage is applied across the external electrodes, the active regions are caused to expand resulting in an extension of the stack length along the direction of the applied field. When the voltage is removed, the stack length is caused to contract. By controlling the voltage across the stack 10, and so varying the stack length, the valve needle of the injector is moved towards and away from a valve seat to control injection into the associated engine. Typically, the voltage across the stack 10 is controlled by means of an engine control unit (ECU) (not shown).

The piezoelectric stack 10 is provided with positive and negative terminals 22, 24 (shown only in Figure 2) at its upper end which connect with a respective one of the positive and negative external stack electrodes 18, 20 via a respective base connector plate 26, 28 at the upper end of the stack 10.

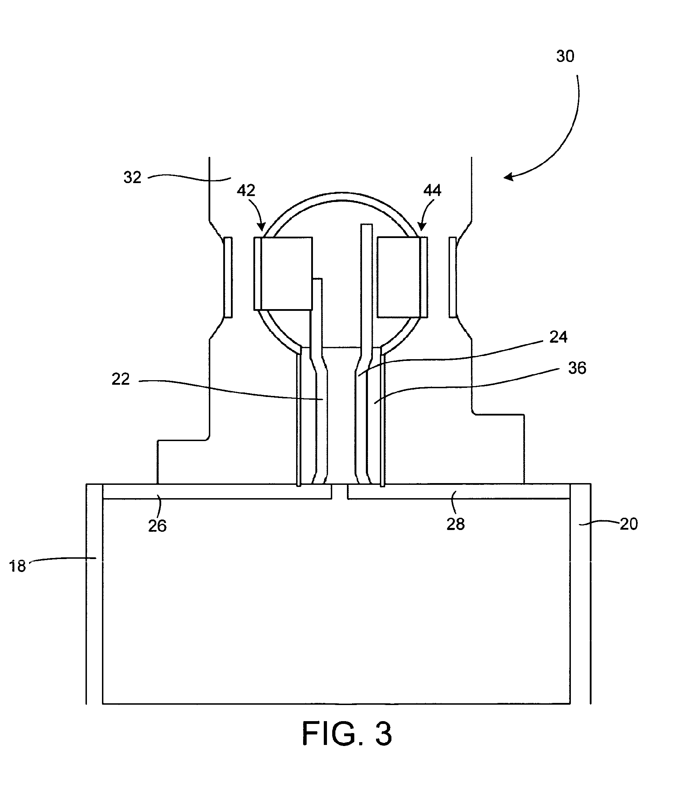

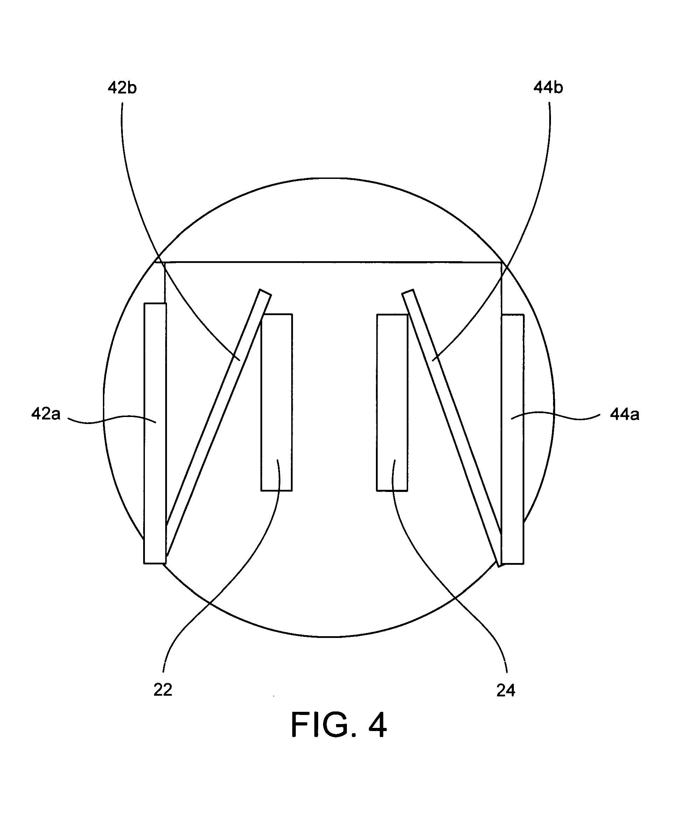

Referring also to Figures 3 to 5, the actuator is further provided with an electrical connector means 30 (not shown in Figure 1 and 2) by means of which the voltage is applied across the stack 10 via the positive and negative actuator terminals 22, 24. At their free ends 22a, 24a, the positive and negative actuator terminals 22, 24 connect with respective positive and negative terminals (not shown) of the electrical connector means 30 to complete the electrical path between the voltage supply of the ECU and the stack external electrodes 18, 20.

The electrical connector means 30 takes the form of an electrical connector having an outer electrical connector body 32 housing the positive and negative connector terminals. The outer electrical connector body 32 is shaped to define a recess 34 at one end to accommodate the upper end of the stack 10, together with the actuator terminals 22, 24. The actuator terminals 22, 24 are embedded within an insulator body 36 to ensure no inadvertent short circuit can occur across the terminals 22, 24. The electrical connector 30 further includes an inner connector body 38, of tubular form, which projects into the recess 34. The positive and negative connector terminals extend at least part way through the tubular body 38, which receives the actuator terminals 22, 24 when the parts are assembled together to enable the terminals 22, 24 of the actuator and the terminals of the connector to be connected together.

The piezoelectric actuator is also provided with a conduction means at its upper end, including first and second movable conductive elements 42, 44. The first and second movable conductive elements 42, 44 are resilient members in the form of leaf springs, one of which (element 42) is connectable with the positive actuator terminal 22 and the other of which (element 44) is connectable with the negative actuator terminal 24. The positive leaf spring includes a ground portion 42a, which connects permanently with ground potential (0 Volts), and a contact portion 42b which connects with the positive actuator terminal 22. Likewise, the negative leaf spring 44 includes a ground portion 44a, which connects permanently with ground potential (0 Volts), and a contact portion 44b which connects with the negative actuator terminal 24. Typically, the ground connection is implemented by connecting the leaf springs 42, 44 with a part of the injector housing (earth) within which the actuator is installed.

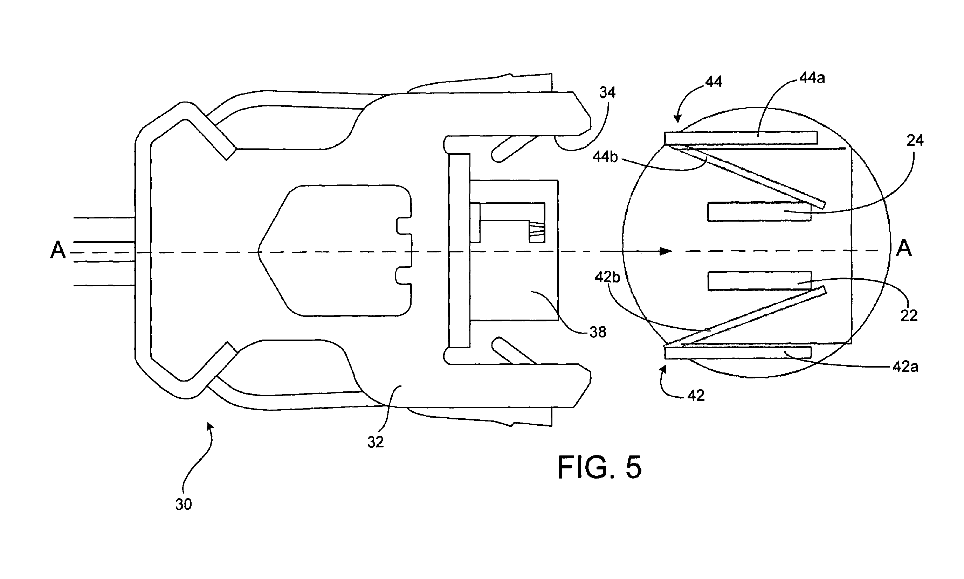

Referring in particular to Figure 5, in order to connect the external voltage supply with the external actuator electrodes 18, 20, the electrical connector 30 is fitted onto the upper end of the actuator stack 10 by moving the parts 30, 10 into engagement with one another along a connection axis A-A. Typically this is done by holding the actuator stack 10 in a fixed position and moving the electrical connector 30 relative to the actuator, as indicated by the arrow. Equally, however, both parts 30, 10 may be moved towards one another along the connection axis A-A, or the electrical connector 30 may be held steady while the actuator stack 10 is moved along the axis A-A.

Initially, with the electrical connector 30 disconnected from the actuator stack 10 (as shown in Figure 5), the leaf springs 42, 44 are urged into contact with their respective stack terminals 22, 24, under their own resilience, so that each of the actuator terminals 22, 24 is grounded (earthed). When the electrical connector 30 is moved relative to the actuator stack 10 along the connection axis, A-A, the actuator terminals 22, 24 are introduced into the connector recess 34 and terminals of like polarity make contact with one another (i.e. the positive connector terminal mates with the positive actuator terminal 22 and the negative connector terminal mates with the negative actuator terminal 24).

As the actuator terminals 22, 24 are introduced into the recess 34, the inner connector body 38 makes contact with the contact portions 42b, 44b of the leaf springs. The contact portion 42b, 44b of each leaf spring defines a ramp-like surface for the inner connector body 38 so that, as the connector 30 is moved further along the connection axis A-A, cooperation between the inner connector body 38 and the contact portions 42b, 44b serves to urge the contact portions 42b, 44b of the leaf springs out of contact from their respective actuator terminal 22, 24. Thus, when the electrical connector 30 is fully fitted onto the actuator terminals 22, 24, the leaf springs 42, 44 are separated from the actuator terminals 22, 24 by means of the inner connector body 38 and, thus, the connection of each terminal 22, 24 to ground is broken.

In order to disconnect the electrical connector 30 from the actuator stack 10, the electrical connector 30 is withdrawn along the connection axis A-A, breaking the connection between the actuator and connector terminals. As the inner connector body 38 is withdrawn from contact with the leaf springs 42, 44, the springs 42, 44 are urged back into contact with the actuator terminals under their own resilience so as to re-establish the connection of the actuator terminals 22, 24 to ground potential via the injector body.

It is an advantage of the invention that when the electrical connector 30 is disconnected from the actuator stack by a user, at which time there is a risk of a user inadvertently touching the actuator terminals 22, 24, the leaf springs 42, 44 are automatically brought into contact with the actuator terminals 22, 24, so providing a short circuit between the actuator terminals and ground and allowing charge on the stack to drain. This removes the risk of an electrical shock to the user. The corollary of this is that when the electrical connector 30 is fitted onto the actuator stack 10 to connect their respective terminals together, the leaf springs 42, 44 are automatically disconnected from the actuator terminals 22, 24 by the inner connector body 38. This ensures that during normal operation of the actuator when the electrical connector 30 is fitted to the stack 10, the short circuit is broken and there is no conduction path to allow charge on the stack to drain. Normal operation of the actuator is therefore in no way affected by the provision of the movable conductive elements 42, 44. The arrangement also provides a benefit for the electrical efficiency of the ECU as no wasted electricity flows through any shorting resistance, other than when the connector is removed.

Each leaf spring 42, 44 presents a very low, or substantially zero, resistance to the flow of charge to drain when the electrical connector 30 is disconnected from the actuator stack. Alternatively, the leaf springs 42, 44 may have a resistance value which allows a more controlled drain of charge (e.g. around 100kΩ or so).

It will be appreciated that the particular shaping of the inner connector body 38 as a tube is not essential to the present invention, and the connector 30 may be shaped in alternative ways whilst still providing the effect of engaging the resilient conductive elements 42, 44 to urge them out of contact with the actuator terminals 22, 24 as the connector terminals and the actuator terminals are brought into electrical contact. Other shapes for the connector body 32 are also envisaged, providing that when the connector 30 is fitted to the actuator stack 10 it serves to isolate electrically the actuator terminals from the short circuit elements 42, 44. The part of the connector body 32 that provides the required insulation may be any connector housing part, or other portion of the connector module 30, and not necessarily an inner connector body tube 38.

In an alternative embodiment (not shown), the conduction means need not include conductive elements 42, 44 which are themselves resilient in nature but may include conductive elements having an additional biasing means, such as a separate spring, for biasing them into contact with the positive and negative electrodes 22, 24.

In a further alternative embodiment of the invention (again not shown), the conduction means may be configured so as to bring the positive and negative actuator terminals 22, 24 into contact with one another as the electrical connector 30 is fitted onto the actuator stack 10, rather than connecting each of the terminals 22, 24 independently to ground.

By way of example, the conduction means may include a single spring element which is resiliently biased into engagement with the positive and negative actuator electrodes 22, 24 so as to provide a high resistance path across the external stack electrodes. The conductive element may take the form of a sprung plate including a contact portion which connects with the positive and negative actuator terminals when the electrical connector is disconnected from the actuator. The provision of the conductive element across the actuator terminals provides a similar function to the leaf springs 42, 44 described with reference in Figures 3 to 5 in that it allows charge that has built up within the stack 10 to be dissipated. As before, charge is only dissipated when the electrical connector 30 is removed from the actuator stack so as to allow the resistive plate to spring back into contact with the actuator terminals 22, 24 to provide a short circuit between them. When the electrical connector 30 is fitted to the actuator terminals 22, 24, the resistive plate is disconnected from the actuator terminals and the charge drain path is disconnected.

The embodiment in which the charge drains from the stack through a short circuit across the actuator terminals 22, 24 can be used to provide a controlled discharge of the stack if the common conductive element which connects across the actuator terminals 22, 24 has a nominal resistance, for example around 100 k, to allow the charge on the stack 10 to drain over a period of a few seconds. Alternatively, the common conductive element may take the form of a metal wire with very low, or substantially no, resistance, in which case the charge drain function is less well controlled.

It will be appreciated that various further modifications to the aforementioned embodiments are possible without departing from the scope of the invention set out in the accompanying claims.

## Claims

1. A piezoelectric actuator arrangement for use in a fuel injector, the piezoelectric actuator comprising:
a piezoelectric body (10),
a positive actuator terminal (22) and a negative actuator terminal (24) across which a voltage and/or charge is applied, in use, so as to actuate the piezoelectric body (10),
electrical connection means (30) for electrically connecting with the positive and negative actuator terminals (22, 24) so as to enable voltage and/or charge supply to the positive and negative actuator terminals (22, 24), and
conduction means (42, 44) operable to connect with the positive and negative actuator terminals (22, 24) so as to allow charge to dissipate from the stack (10) when the electrical connection between the electrical connection means (30) and the positive and negative actuator terminals (22, 24) is broken and to disconnect from the positive and negative actuator terminals (22, 24) when the electrical connection means (30) and the positive and negative actuator terminals (22, 24) are electrically connected.

2. The piezoelectric actuator as claimed in claim 1, wherein the conduction means includes a movable conductive element (42, 44) which is urged into connection with at least one of the positive and negative actuator terminals (22, 24) by means of a biasing force when the electrical connection between the electrical connection means (30) and the positive and negative actuator terminals (22, 24) is broken.

3. The piezoelectric actuator as claimed in claim 2, wherein the electrical connection means includes a connector body (32, 38) which urges the conductive element (42, 44) out of contact with the positive and/or negative actuator terminal (22, 24), against the biasing force, when the electrical connection means (30) is electrically connected with the positive and negative actuator terminals (22, 24).

4. The piezoelectric actuator as claimed in claim 3, wherein the electrical connection means includes positive and negative connector terminals for electrical connection with respective ones of the positive and negative actuator terminals (22, 24) and wherein the connector body is a tubular connector body (38) housing at least a part of the positive and negative connector terminals.

5. The piezoelectric actuator as claimed in any one of claims 1 to 4, wherein the conductive element serves to connect the positive and negative actuator terminals (22, 24) to ground when the electrical connection between the electrical connection means (30) and the positive and negative actuator terminals (22, 24) is broken.

6. The piezoelectric actuator as claimed in claim 5, including a first conductive element (42) which connects the positive actuator terminal (22) to ground and a second conductive element (44) which connects the negative actuator terminal (24) to ground when the electrical connection between the electrical connection means (30) and the positive and negative actuator terminals (22, 24) is broken.

7. The piezoelectric actuator as claimed in claim 6, wherein the first and second conductive elements are resilient elements (42, 44).

8. The piezoelectric elements as claimed in claim 7, wherein each of the first and second conductive elements (42, 44) includes a ground portion (42a, 44a) in permanent connection with ground potential and a contact portion (42b, 44b) which is movable to connect with a respective one of the positive and negative actuator terminals (22, 24).

9. The piezoelectric actuator as claimed in claim 6, wherein each of the first and second conductive elements is urged by means of a biasing force, provided by a separate resilient element, into connection with the respective one of the positive and negative actuator terminals (22, 24).

10. The piezoelectric actuator as claimed in any one of claims 7 to 9, wherein the resilient elements (42, 44) are leaf springs.

11. The piezoelectric actuator as claimed in any one of claims 2 to 4, wherein the conductive element connects across the positive and negative terminals when the electrical connection between the electrical connection means and the positive and negative actuator terminals is broken.

12. The piezoelectric actuator as claimed in claim 11, wherein the conductive element includes a resilient element which is urged by means of a biasing force into a position in which it connects across the positive and negative actuator terminals when the electrical connection between the electrical connection means and the positive and negative actuator terminals is broken.

13. The piezoelectric actuator as claimed in claim 11, wherein the conductive element is urged by means of a biasing force provided by a separate resilient element into a position in which it connects across the positive and negative actuator terminals when the electrical connection between the electrical connection means and the positive and negative actuator terminals is broken.

14. The piezoelectric actuator as claimed in claim 12 or claim 13, wherein the resilient element is a leaf spring.

15. The piezoelectric actuator as claimed in any one of claims 1 to 14, wherein the piezoelectric body includes a stack of piezoelectric elements formed from a piezoelectric material.

16. A fuel injector for use in an internal combustion engine including a valve needle for controlling injection into the engine and an actuator as claimed in any one of claims 1 to 15 for controlling the valve needle.
